(19) Europäisches Patentamt
European Patent Office
Office européen des brevets

(11) **EP 3 977 148 B1**

(12) **FASCICULE DE BREVET EUROPEEN**

(45) Date de publication et mention de la délivrance du brevet:
**15.05.2024 Bulletin 2024/20**

(21) Numéro de dépôt: **20729063.6**

(22) Date de dépôt: **28.05.2020**

(51) Classification Internationale des Brevets (IPC):
**G01R 33/035** (2006.01) **G01R 33/00** (2006.01)

(52) Classification Coopérative des Brevets (CPC):
**G01R 33/0354; G01R 33/0094;** G01R 33/0017

(86) Numéro de dépôt international:
**PCT/EP2020/064846**

(87) Numéro de publication internationale:
**WO 2020/239914 (03.12.2020 Gazette 2020/49)**

(54) **DISPOSITIF DE DÉTECTION DE CHAMP MAGNÉTIQUE**

MAGNETFELDSENSOR

MAGNETIC FIELD SENSING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.05.2019 FR 1905629**

(43) Date de publication de la demande:
**06.04.2022 Bulletin 2022/14**

(73) Titulaire: **THALES**
**92400 Courbevoie (FR)**

(72) Inventeur: **CRETE, Denis**
**91767 Palaiseau (FR)**

(74) Mandataire: **Lavoix**
**2, place d'Estienne d'Orves**
**75441 Paris Cedex 09 (FR)**

(56) Documents cités:
- **LABBÉ A ET AL: "Effects of flux pinning on the DC characteristics of meander-shaped superconducting quantum interference filters with flux concentrator", JOURNAL OF APPLIED PHYSICS, AMERICAN INSTITUTE OF PHYSICS, US, vol. 124, no. 21, 7 décembre 2018 (2018-12-07), XP012233756, ISSN: 0021-8979, DOI: 10.1063/1.5040051 [extrait le 2018-12-07]**
- **CYBART SHANE A ET AL: "Comparison of measurements and simulations of series-parallel incommensurate area superconducting quantum interference device arrays fabricated from YBaCuO ion damage Josephson junctions", JOURNAL OF APPLIED PHYSICS, AMERICAN INSTITUTE OF PHYSICS, US, vol. 112, no. 6, 15 septembre 2012 (2012-09-15), pages 63911-63911, XP012166813, ISSN: 0021-8979, DOI: 10.1063/1.4754422 [extrait le 2012-09-21]**
- **KORNEV V K ET AL: "Broadband active electrically small superconductor antennas", SUPERCONDUCTOR SCIENCE AND TECHNOLOGY, IOP PUBLISHING, TECHNO HOUSE, BRISTOL, GB, vol. 30, no. 10, 16 août 2017 (2017-08-16) , page 103001, XP020319838, ISSN: 0953-2048, DOI: 10.1088/1361-6668/AA7A52 [extrait le 2017-08-16]**

**Description**

La présente invention concerne un dispositif de détection de champ magnétique.

Il est connu que, parmi les détecteurs de champ magnétique les plus sensibles, ceux qui possèdent la plus grande bande passante comprennent des composants supraconducteurs qui utilisent l'effet Josephson.

Par définition, l'effet Josephson se manifeste par l'apparition d'un courant, également appelé supracourant, entre deux matériaux supraconducteurs séparés par une couche non conductrice, par exemple formée d'un matériau isolant ou métallique non supraconducteur. L'ensemble des deux matériaux supraconducteurs et de la couche est appelé une jonction Josephson. L'apparition de ce courant s'explique par la théorie macroscopique de la supraconductivité développée par John Bardeen, Leon Cooper et Robert Schrieffer. Selon cette théorie, en dessous de la température de transition supraconductrice, au moins une partie des électrons libres dans le matériel supraconducteur sont liés entre eux, de manière à former des paires d'électrons dites « paires de Cooper ».

La supraconductivité est un phénomène quantique macroscopique induisant trois conséquences principales : une conductivité électrique infinie justifiant l'existence d'un courant permanent de paires de Cooper dans un anneau supraconducteur, la quantification du flux magnétique à travers un anneau supraconducteur résultant de l'apparition d'un champ magnétique et du courant induit dans l'anneau et l'effet Josephson aussi appelé « effet tunnel Josephson ».

Il est notamment connu depuis la fin des années soixante d'utiliser un dispositif supraconducteur d'interférence quantique, plus souvent désigné sous l'acronyme anglais dispositif SQUID, qui renvoie à « Superconducting QUantum interférence Device » pour la détection de champs magnétiques.

Un dispositif SQUID est une boucle supraconductrice (piste fermée formée d'au moins un matériau supraconducteur, électriquement équivalente à une inductance de valeur I) interrompue par au moins une couche isolante, chaque interruption formant une jonction Josephson.

Ces détecteurs de champs magnétiques sont alimentés par un courant de polarisation.

Le courant de polarisation induit un champ magnétique qui est généré par les jonctions Josephson du dispositif SQUID, appelé champ magnétique auto-induit ou encore champ magnétique parasite.

Il est en particulier connus de l'article de Labbé et al., intitulé « Effects of flux pinning on the DC characteristics of meander-shaped superconducting quantum interférence filters with flux concentrator", de l'article de Cybart et al., intitulé « Comparison of measurements and simulations of series-parallel incommensurate area superconductivity quantum interférence device arrays fabricated from YBa2Cu7O7-δ ion damage Josephson junctions » et de l'article de Kornev et al., intitulé « Broadband active electrically small superconductor antennas » des dispositifs de détection de champ magnétique.

Pour un dispositif SQUID symétrique, c'est-à-dire ayant deux branches parallèles comprenant chacune une jonction Josephson, les courants de polarisation de chaque branche du dispositif SQUID ont deux contributions au flux magnétique à travers la boucle du dispositif SQUID qui s'annulent. Il n'y a donc pas d'erreur de mesure due à la polarisation du dispositif SQUID.

Ceci n'est pas toujours le cas lorsque qu'un circuit comprend plusieurs dispositifs SQUID, ou d'autres détecteurs de champ magnétique nécessitant un courant de polarisation. Or, il est particulièrement avantageux d'utiliser des circuits comprenant plusieurs dispositifs SQUID pour améliorer les performances de détection des champs magnétiques.

Il est donc souhaitable de disposer dans l'espace les dispositifs SQUID les uns par rapport aux autres de sorte à minimiser la détection par dispositifs SQUID du circuit des champs magnétiques auto-induits générés par ces dispositifs SQUID.

Par exemple, dans le cas où le circuit présente la forme d'une épingle à cheveu ou autrement dit, la forme d'un « U », le circuit comprend deux segments parallèles comprenant chacun des dispositifs SQUID.

Chacun des deux segments du circuit crée un champ magnétique auto-induit identique sur l'autre segment du circuit. Tous les dispositifs SQUID sont alors soumis au même champ magnétique parasite. Le champ magnétique auto-induit peut être compensé par l'utilisation d'un champ magnétique uniforme par exemple généré par une ou plusieurs bobines de grand diamètre, c'est-à-dire ayant un diamètre suffisant grand pour créer un champ magnétique uniforme à l'échelle du circuit.

L'utilisation des bobines a pour inconvénient d'augmenter la dimension du circuit et de fait, empêche l'utilisation d'un tel circuit pour certains domaines d'application.

De plus, dans le cas où le circuit présente plus de deux segments, il n'est plus possible de compenser par des bobines le champ magnétique auto-induit.

Il existe donc un besoin pour un détecteur de champ magnétique dans lequel le champ magnétique auto-induit est compensé et qui présente une meilleure compacité.

A cet effet, la présente description propose un dispositif de détection de champ magnétique selon la revendication 1.

D'autres modes de réalisation sont décrits dans les revendications dépendantes.

Suivant des modes de réalisation particuliers, le dispositif de détection de champ magnétique comprend, entre autres, une ou plusieurs des caractéristiques suivantes :

- la portion d'entrée comprend un premier nombre de segments d'entrée et la portion de sortie comprend un deuxième nombre de segments de sortie, le premier nombre étant égal au deuxième nombre.

Il apparaît que la piste conductrice ayant la forme d'un serpentin, la piste conductrice comprend une pluralité de segments et des parties de raccordement raccordant les segments entre eux.

Un segment désigne une portion de piste de forme parallélépipédique tellement allongée le long d'une direction qu'elle peut être représentée par un segment mathématique reliant deux extrémités.

Une partie de raccordement est une partie de la piste conductrice raccordant un segment à un segment successif.

Autrement dit, au moins une extrémité d'un segment est raccordée à une autre extrémité d'un segment par l'intermédiaire d'une partie de raccordement.

Dans le présent cas de figure, les segments de la piste conductrice sont les portions de la piste conductrice qui s'étendent chacune le long d'une deuxième direction et qui sont espacées les unes des autres le long d'une première direction alors que les parties de raccordement s'étendent principalement chacune le long d'une première direction perpendiculaire à la deuxième direction.

Ainsi, les segments sont des portions de la piste conductrice s'étendant selon la deuxième direction et agencées en vis-à-vis les unes des autres de manière parallèle selon la première direction alors que les parties de raccordement s'étendent selon la première direction et sont agencées de manière parallèle selon la deuxième direction.

En outre, par exemple, la dimension d'un segment est au moins deux fois supérieure à la dimension d'une portion de raccordement reliant ce segment à un autre segment successif.

On comprend alors que le segment d'entrée et le segment de sortie s'étendent chacun le long de la deuxième direction et sont agencés en vis-à-vis l'un de l'autre selon la première direction.

- la portion intermédiaire comprend une pluralité de segments, dits segments intermédiaires, le nombre de segments intermédiaires étant de préférence supérieur ou égal à trois, le nombre de segments intermédiaires étant de préférence impair.

Les segments intermédiaires sont des portions de la piste conductrice qui s'étendent le long de la deuxième direction et qui sont agencées en vis-à-vis les unes aux autres de manière parallèles selon la première direction.

En outre un segment intermédiaire est raccordé à un segment intermédiaire successif par une partie de raccordement.

D'autres caractéristiques et avantages de l'invention apparaîtront à la lecture de la description qui suit de modes de réalisation de l'invention, donnée à titre d'exemple uniquement en référence aux dessins qui sont:

- figure 1, une représentation schématique d'un exemple dispositif de détection de champ magnétique;
- figure 2, un graphique représentant un exemple de distribution spatiale du champ magnétique auto-induit créé au niveau d'éléments détecteurs du dispositif de détection dépourvu de portion d'entrée et de portion de sortie et la variation spatiale d'un champ magnétique correctif du dispositif de détection de la figure 1 ;
- figure 3, une variation spatiale du champ magnétique résiduel obtenu après une compensation du champ magnétique auto-induit représentée sur la figure 2 ;
- figure 4, une représentation schématique d'un autre exemple de dispositif de détection de champ magnétique;
- figure 5, une représentation schématique d'une variante de dispositif de détection de champ magnétique;
- figure 6, une représentation schématique en coupe d'encore un autre exemple de dispositif de détection de champ magnétique ;
- figure 7, un graphique représentant un autre exemple de distribution spatiale du champ magnétique auto-induit créé au niveau d'éléments détecteurs du dispositif de détection dépourvu de portion d'entrée et de portion de sortie et la variation spatiale d'un champ magnétique correctif d'un dispositif de détection selon encore un autre exemple de réalisation du dispositif de détection; et
- figure 8, la variation spatiale du champ magnétique auto-induit résiduel après une compensation du champ magnétique auto-induit représentée sur la figure 7.

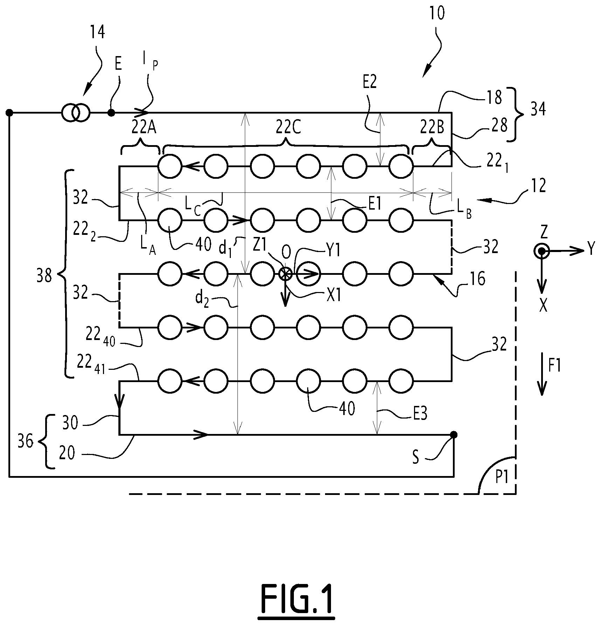

Un dispositif de détection 10 de champ magnétique est représenté schématiquement sur la figure 1.

Le dispositif de détection 10 est propre à détecter un champ magnétique.

Dans la suite de la présente description, il est défini une première direction. La première direction est symbolisée sur les figures par un axe X. La première direction est donc désignée par l'expression « première direction X » dans le reste de la description.

Une deuxième direction est également définie comme étant perpendiculaire à la première direction X. La deuxième direction est symbolisée sur les figures par un axe Y. La deuxième direction est donc désignée par l'expression « deuxième direction Y » dans le reste de la description.

Il est aussi défini une troisième direction définie comme étant perpendiculaire à la première direction X et à la deuxième direction Y. La troisième direction est symbolisée sur les figures par un axe Z. La troisième direction est donc désignée par l'expression « troisième direction Z » dans le reste de la description.

Le dispositif de détection 10 comprend un circuit 12 propre à être parcouru par un courant de polarisation $I_p$ et un générateur 14 de courant de polarisation $I_p$.

Le circuit 12 comprend au moins une entrée E, une sortie S et une piste conductrice 16 propre à être parcourue par le courant de polarisation $I_p$.

Le circuit 12 s'étend dans un premier plan P1. Le premier plan P1 est normal à la troisième direction Z.

Il est défini un repère R attaché au circuit 12, le repère R est noté (O, X1, Y1, Z1). O est le centre du repère, X1 est un premier axe parallèle à la première direction X, Y1 est un deuxième axe parallèle à la deuxième direction Y, et Z1 est un troisième axe parallèle à la troisième direction Z. Il est aussi défini une première coordonnée spatiale, notée x, variant le long du premier axe X1 à partir du centre O du repère R.

Le générateur de courant 14 est propre à injecter le courant de polarisation $I_p$ dans la piste conductrice 16.

Le générateur 14 de courant de polarisation $I_p$ est relié à l'entrée E du circuit 12.

Le générateur 14 de courant de polarisation $I_p$ est connecté à la piste conductrice 16.

Le courant de polarisation $I_p$ parcourt la piste conductrice 16 depuis l'entrée E du circuit vers la sortie S du circuit 12. Dans le cas de figure le plus simple, la sortie S est connectée au générateur de courant 14.

La piste conductrice 16 présente la forme d'un serpentin. Autrement dit, la piste conductrice 16 présente une forme en méandre.

Plus précisément, la piste conductrice 16 comporte une pluralité de segments 18, 20, 22 et des parties de raccordement 28, 30, 32 raccordant les segments 18, 20, 22 entre eux.

Chaque segment 18, 20, 22 s'étend le long de la deuxième direction Y.

Les segments 18, 20, 22 sont agencés en vis-à-vis les uns des autres selon la première direction X.

Dans le présent exemple, les longueurs des segments 18, 20 et 22 sont égales.

Il est entendu dans la suite de la description par l'expression « longueur d'un segment », la dimension du segment 18, 20, 22 mesurée selon la deuxième direction Y. Il est entendu dans la présente description par l'expression « longueur d'un segment de raccordement », la dimension du segment de raccordement 34, 36, 38 mesurée selon la première direction X.

En outre, dans la présente description, il est entendu par l'expression « espacement » la distance mesurée entre deux segments 18, 20, 22 consécutifs selon la première direction transversale X.

Chaque partie de raccordement 28, 30, 32 s'étend le long de la première direction X.

La piste conductrice 16 comprend au moins une portion d'entrée 34, au moins une portion de sortie 36, au moins une portion intermédiaire 38.

La portion intermédiaire 38 présente un centre.

Le centre de la portion intermédiaire 38 est le centre O du repère R attaché au circuit 12.

Dans l'exemple de réalisation de la figure 1, la portion d'entrée 34 comprend au moins le segment 18, dit segment d'entrée et au moins la partie de raccordement 28 raccordant le segment d'entrée 18 à la portion intermédiaire 38.

Il est entendu dans la suite de la présente description par l'expression « longueur de la portion d'entrée », la somme des longueurs des segments d'entrée 18 et des parties de raccordement 28 de la portion d'entrée 34. La longueur de la portion d'entrée 34 est nommée dans la suite « longueur d'entrée » et notée « longueur d'entrée $L_E$ ».

La portion d'entrée 34 comprend un premier nombre N1 de segments d'entrée 18, noté N1. Dans le présent exemple, le premier nombre N1 est égal à un.

Dans le présent exemple, la portion d'entrée 34 a pour coordonnée xE dans le repère R. La coordonnée xE correspond à la position du segment d'entrée 18 sur le premier axe X1.

La portion d'entrée 34 est dépourvue d'élément détecteur de champ magnétique.

Autrement dit, le segment d'entrée 18 et la partie de raccordement 28 de la portion d'entrée 34 sont dépourvus d'élément détecteur de champ magnétique.

Dans la présente description, un élément détecteur de champ magnétique est apte à détecter un champ magnétique. Par exemple, un détecteur de champ magnétique comprend au moins une jonction Josephson.

La portion de sortie 36 comprend au moins le segment 20, dit segment de sortie et la partie de raccordement 30 raccordant la portion intermédiaire 38 au segment de sortie 20.

Il est entendu dans la suite de la présente description par l'expression « longueur de la portion de sortie », la somme des longueurs des segments de sortie 20 et des parties de raccordement 30 de la portion de sortie 36. La longueur de la portion de sortie est nommée « longueur de sortie » et notée « longueur de sortie $L_S$ ».

La portion de sortie 36 comprend un deuxième nombre de segments de sortie, noté N2. Dans le présent exemple, le deuxième nombre N2 est égal à un.

De préférence, le deuxième nombre N2 est égal au premier nombre N1.

Dans le présent exemple, la portion de sortie 36 a pour coordonnée xS dans le repère R. La coordonnée xS correspond à la position du segment de sortie 22 sur le premier axe X1.

Par exemple, la longueur du segment d'entrée 18 et la longueur du segment de sortie 20 sont égales.

La portion de sortie 36 est dépourvue d'élément détecteur de champ magnétique. Autrement dit, le segment de sortie 20 et la partie de raccordement 30 de la portion de sortie 36 sont dépourvus d'élément détecteur de champ magnétique.

La portion intermédiaire 38 est intercalée entre la portion d'entrée 34 et la portion de sortie 36.

Autrement dit, la portion intermédiaire 38 est superposée à la portion d'entrée 34 et à la portion de sortie 36 selon la première direction X et est agencée entre la portion d'entrée 34 et la portion de sortie 36. Ainsi, la portion intermédiaire 38 est « prise en sandwich » entre la portion d'entrée 34 et la portion de sortie 36.

La portion intermédiaire 38 comprend une pluralité de segments 22, dits segments intermédiaires et une pluralité de parties de raccordement 32 raccordant les segments intermédiaires 22 les uns aux autres. La portion intermédiaire 38 comprend, en outre, une pluralité de détecteurs 40 de champ magnétique aussi appelés « éléments détecteurs ». Les détecteurs 40 de champ magnétique comprennent, par exemple, des jonctions Josephson.

Ainsi, les segments intermédiaires 22 sont superposés à la portion d'entrée 34 et à la portion de sortie 26 selon la première direction X et sont agencés entre la portion d'entrée 34 et la portion de sortie 36.

Les détecteurs 40 sont électriquement connectés en série les uns aux autres.

Par exemple, chaque élément détecteur 40 est un dispositif de détection à interférence quantique, encore appelé dispositif SQUID (« Superconducting QUantumInterference Device » en anglais).

Chaque dispositif SQUID comprend au moins une jonction Josephson.

La portion intermédiaire 38 comprend un troisième nombre de segments intermédiaires 22, noté N3.

Le troisième nombre N3 est au moins égal à trois. Par exemple, le troisième nombre N3 est compris entre 3 et 500.

Dans le présent exemple décrit, le troisième nombre N3 est impair.

A titre d'illustration, le troisième nombre N3 est égal à 41. Seul cinq segments intermédiaires 22 sont représentés. Les pointillés indiquent que la piste conductrice 16 comprend plus de cinq segments intermédiaires 22.

Les segments intermédiaires 22 sont ordonnés par rapport au sens de circulation du courant de polarisation $I_p$ circulant dans la piste conductrice 16 depuis l'entrée E vers la sortie S du circuit 12. Le sens de circulation est identifié par une flèche F1 sur la figure 1.

Il est donc possible d'identifier les segments intermédiaires 22 par un indice k entier variant de 1 à N3. Les segments intermédiaires peuvent donc être notés $22_k$. L'indice k est omis lorsque qu'un segment intermédiaire quelconque est désigné.

Il est noté $x_k$, l'abscisse d'un segment intermédiaire $22_k$ dans le repère R.

Il est ainsi défini une succession de segments intermédiaires depuis un premier segment intermédiaire $22_1$ jusqu'à un N3-ième segment intermédiaire $22_{N3}$ appelé « dernier segment intermédiaire $22_{N3}$ ».

En particulier, le premier segment intermédiaire $22_1$ est connecté à la partie de raccordement 28 de la portion d'entrée 34 et le quarante-et-unième segment intermédiaire $22_{41}$ (formant le dernier segment intermédiaire $22_{N3}$) est connecté à la partie de raccordement 30 de la portion de sortie 36.

Il est défini un premier espacement, noté E1, entre les centres de deux segments intermédiaires 22 consécutifs.

Selon l'exemple décrit, le premier espacement E1 est constant. Par exemple, le premier espacement E1 est compris entre 2 micromètres ($\mu$m) et 100 $\mu$m.

Il est aussi défini un deuxième espacement, noté E2, entre le segment d'entrée 18 et le premier segment intermédiaire $22_1$. Le deuxième espacement E2 correspond à l'espacement entre la portion intermédiaire 38 et la portion d'entrée 34.

Il est également défini un troisième espacement noté E3 entre le dernier segment intermédiaire $22_{N3}$ et le segment de sortie 20. Le troisième espacement E3 correspond à l'espacement entre la portion intermédiaire 36 et la portion de sortie 36.

Comme visible sur la figure 1, chaque segment intermédiaire 22 comprend deux portions d'extrémités 22A, 22B et une portion médiane 22C.

Pour chaque segment intermédiaire 22, il est défini une longueur $L_A$, $L_B$ pour chaque portion d'extrémité 22A, 22B respective. Pour chaque segment intermédiaire 22, il est aussi défini une longueur $L_C$ pour la portion médiane 22C.

Par le terme « longueur $L_A$, $L_B$ de chaque portion d'extrémité 22A, 22B », il est entendu la dimension de cette portion d'extrémité 22A, 22B mesurée selon la deuxième direction transversale Y.

Par « longueur $L_c$ de la portion médiane 22C », il est entendu la dimension de la portion médiane 22C mesurée selon la deuxième direction transversale Y.

Par exemple, les longueurs $L_A$, $L_B$ de chacune des portions d'extrémité 22A, 22B sont égales.

Par exemple, chaque portion d'extrémité 22A, 22B présente une longueur $L_A$, $L_B$ comprise entre la moitié de E1 et 200 $\mu$m.

Par exemple, la longueur $L_C$ de la portion médiane 22C est égale à 1 mm.

La longueur $L_c$ de la portion médiane 22C de chaque segment intermédiaire 22 est, par exemple, inférieure à 80% de la longueur L de ce segment intermédiaire 22. La longueur L d'un segment intermédiaire 22 est égale à la somme des longueurs $L_A$, $L_B$ de chaque portion d'extrémité et de la longueur $L_c$ de la portion intermédiaire de ce segment intermédiaire 22.

Les détecteurs 40 sont répartis sur la portion médiane 22C de chaque segment intermédiaire 22. Les parties de raccordement 32 de la portion intermédiaire 38 sont dépourvus de détecteurs 40.

Par exemple, chaque segment intermédiaire 22 comprend 100 détecteurs 40.

Par exemple, les détecteurs 40 sont agencés en vis-à-vis les uns des autres selon la première direction X.

La portion intermédiaire 38 présente, de préférence, un contour de la forme d'un quadrilatère, dont on définit le centre O comme étant l'intersection des diagonales du quadrilatère

Dans l'exemple décrit, le centre O est situé au centre du vingtième-et-unième segment intermédiaire $22_{21}$.

Il est défini une première distance $d_1$ entre la portion d'entrée 34 et le centre O de la portion intermédiaire 38. La première distance $d_1$ correspond à la distance entre le centre O et le segment d'entrée 18 adjacent au premier segment intermédiaire $22_1$ mesurée selon la première direction X. La distance $d_1$ est décalée par rapport au centre O sur la figure 1, uniquement pour un souci de visualisation.

Il est aussi défini une deuxième distance $d_2$ entre la portion de sortie 36 et le centre O de la portion intermédiaire 38. La deuxième distance $d_2$ correspond à la distance entre le centre O et le segment de sortie 20 adjacent au dernier segment intermédiaire $22_{N3}$ mesurée selon la première direction X. La distance $d_2$ est décalée par rapport au centre O sur la figure 1, uniquement pour un souci de visualisation.

En particulier, la longueur d'entrée $L_E$, la longueur de sortie $L_S$, la première distance $d_1$, et la deuxième distance $d_2$ sont telles que le champ auto-induit par les éléments détecteurs 40 est diminué d'au moins 99% par rapport au champ auto-induit par les éléments détecteurs 40 d'une piste conductrice 16 dépourvue de portion d'entrée 34 et dépourvue de portion de sortie 36.

Dans l'exemple décrit sur la figure 1, la portion d'entrée 34 et la portion de sortie 36 sont agencées symétriquement par rapport au centre O de la portion intermédiaire 38. Ainsi, le segment d'entrée 18 et le segment de sortie 20 sont symétriques l'un par rapport à l'autre par rapport au centre O.

Autrement dit, la longueur d'entrée $L_E$ d'entrée et la longueur de sortie $L_S$ peuvent être variées pour compenser le champ auto-induit. Afin de varier la longueur d'entrée $L_E$ et la longueur de sortie $L_S$, le premier nombre N1, respectivement le deuxième nombre N2 est modifié.

En outre, la première distance $d_1$ et la deuxième distance $d_2$ peuvent être respectivement modifiées pour faire varier le champ auto-induit et donc compenser le champ auto-induit. Pour cela, le deuxième espacement E2 et le troisième espacement E3 sont respectivement variés.

En fonctionnement du dispositif de détection 10, le courant de polarisation $I_p$ est injecté à l'entrée E du circuit 12. Puis, le courant de polarisation $I_p$ parcourt la portion d'entrée 34, la portion intermédiaire 38 et la portion de sortie 36.

La portion d'entrée et la portion de sortie parcourues par le courant de polarisation $I_p$ sont propres à générer un champ magnétique, appelé champ magnétique correctif.

Le champ magnétique correctif compense le champ magnétique auto-induit généré dans la portion intermédiaire 38. En particulier, le champ auto induit est compensé aux points correspondant à la position des segments intermédiaires $22_k$ de la portion intermédiaire 38.

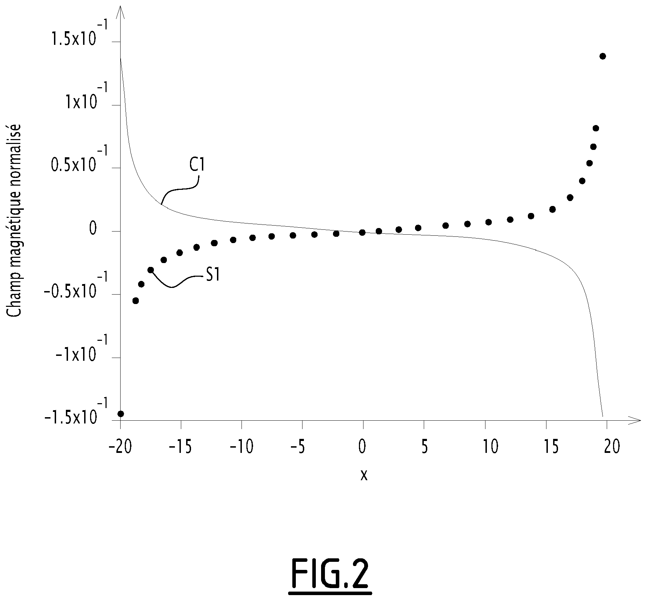

La figure 2 est un graphique comportant une série de données S1 et une courbe C1.

La série de données S1 correspond à la valeur du champ magnétique parasite auto-induit aux points d'abscisse $x_k$ où sont positionnés les segments intermédiaires $22_k$ lorsque le circuit 12 est dépourvu de portion d'entrée 34 et de portion de sortie 36.

Cette série de données peut être approximée par une première fonction, notée $f_N$ :

$$f_{N(x)} = \sum_{i=1}^{N} \frac{J_i}{x - \xi_i}$$

Où

- N est un nombre entier, choisi en fonction de la précision de la compensation du champ magnétique auto-induit souhaitée,
- $\xi i$ et $J_i$ sont des paramètres d'ajustement, les coefficients Ji étant proportionnels au courant $I_p$ circulant dans la portion intermédiaire 38.

L'expression de la fonction $f_N$ peut aussi être vue comme le champ magnétique généré par un système de N segments conducteurs placés aux points $\xi_i$, i étant un nombre entier variant de 1 à N.

De préférence, N est égal à la somme du premier nombre N1 et du deuxième nombre N2 et le premier nombre N1 est égal au deuxième nombre N2.

A titre d'illustration, N est égal à 2. Ainsi, le premier nombre N1 est égal à un et le deuxième nombre N2 est également égal à un. La parité de la fonction $f_N$ est la même que la parité du troisième nombre N3.

Dans le cas où le troisième nombre N3 de segments intermédiaire 22 est impair, par symétrie, $J_1 = J_2$ et $\xi_2 = -\xi_1$.

Alors, le champ parasite peut être évalué aux points d'abscisse $x_k$ des segments $22_k$ par une deuxième fonction, notée $f_2$.

Où :

$$x_k = \left(k - \frac{N3+1}{2}\right).E1 \, , k = 1 \ldots N3,$$

et

$$f_2(x_k) = J_1 . \left(\frac{1}{x_k - \xi_1} + \frac{1}{x_k + \xi_1}\right).$$

L'expression de la fonction $f_2$ peut être vue com-

me le champ magnétique généré par un système de deux segments conducteurs placés en $\xi_1$ et $\xi_2 = -\xi_1$. Avec la disposition en méandre espacés régulièrement, $\xi_1$ est strictement inférieur à $x_1$ et $\xi_2$ est strictement supérieur à $x_{N3}$. Ces deux segments conducteurs forment le segment d'entrée 18 et le segment de sortie 20 des portions d'entrée 34 et de sortie 36 propres à générer un champ correctif ou de compensation du champ parasite aux points présentant une abcisse $x_k$ des segments intermédiaires 22.

La courbe C1 représente la variation spatiale de la première fonction f2 en fonction de la coordonnée spatiale x de telle sorte que le champ magnétique auto-induit soit compensé aux points d'abscisses $x_k$ des segments intermédiaires $22_k$.

En particulier, la courbe C1 représente la formule analytique définissant le paramètre d'ajustement $\xi_1$ par ajustement numérique.

Le paramètre $\xi_1$ est choisi pour que pour chacune des valeurs de coordonnées spatiales $x_k$, la valeur de champ magnétique correctif normalisée donnée par la courbe C1 est opposée à la valeur de champ magnétique auto-induit normalisée correspondante de la série S1.

La valeur du paramètre d'ajustement $\xi_1$ donne les coordonnées xE, xS du segment d'entrée 18 et du segment de sortie 20.

Ainsi, la coordonnée xE du segment d'entrée 18 est égale à $-\xi_1$ et la coordonnée du segment de sortie 20 est égal à $+\xi_1$.

Dans le présent exemple, la coordonnée xE du segment d'entrée 18 est égale à -20,73 multiplié par le premier espacement E1 et la coordonnée xS du segment de sortie 20 égale à 20,73 multiplié par le premier espacement E1.

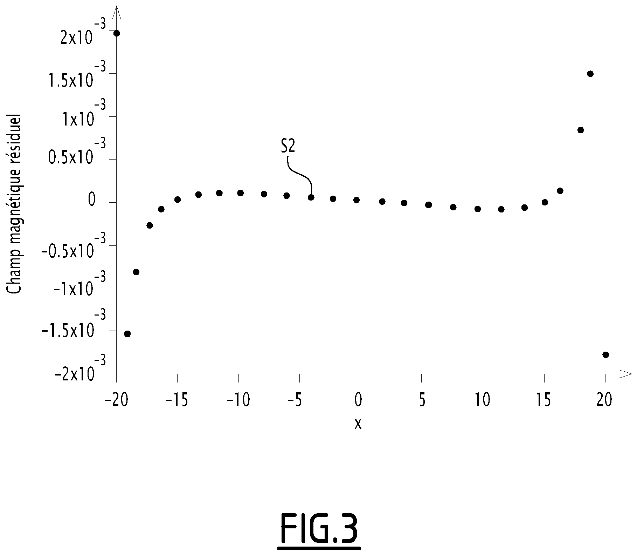

La figure 3, est un graphique comportant une série de points S2.

La série S2 correspond aux valeurs du champ auto-induit résiduel aux positions $x_k$ des segments intermédiaires $22_k$ lorsque le circuit 12 comprend une portion d'entrée 34 et une portion de sortie 36.

Les effets de champ magnétique auto-induits par les éléments détecteurs 40 sont réduits d'un facteur proche de 100 par rapport à une piste conductrice 16 ne comportant pas de portion d'entrée 34 et de portion de sortie 36.

Grâce à la portion d'entrée 34 et à la portion de sortie 36, le champ auto-induit par les éléments détecteurs 40 est diminué d'au moins 99% par rapport au champ auto-induit par un élément détecteur 40 d'une piste conductrice 16 ne comprenant pas de portion d'entrée 34 et de portion de sortie 36, dépourvues chacune de détecteurs 40.

Lorsque le troisième nombre N3 de segments intermédiaires 22 est impair, grâce à la portion d'entrée 34 et à la portion de sortie 36, le champ magnétique auto-induit par les éléments détecteurs 40 de champ magnétique est réduit en $1/N3^2$.

Ainsi, la portion d'entrée 34 et la portion de sortie 36 compensent le champ magnétique auto-induit par les éléments détecteurs 40 de champ magnétique du fait du courant de polarisation $I_p$.

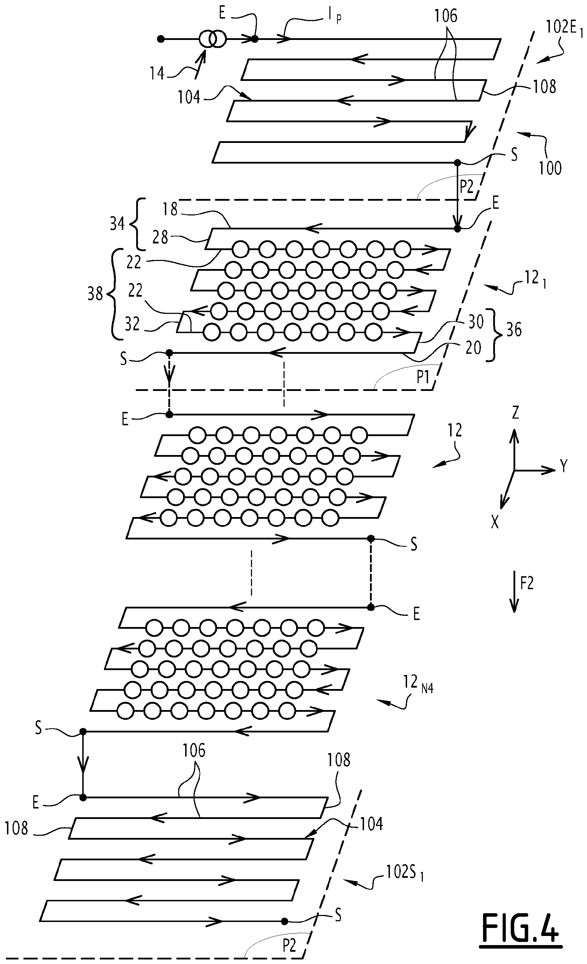

Un deuxième mode de réalisation d'un dispositif de détection de champ magnétique est décrit en référence à la figure 4.

Ce mode de réalisation est décrit uniquement par différence par rapport au mode de réalisation décrit en référence aux figures 1 à 3.

Le dispositif de détection 100 comprend un quatrième nombre N4 de premiers circuits 12, un cinquième nombre N5 de deuxièmes circuits d'entrée 102E et un sixième nombre N6 de deuxièmes circuits de sortie 102S.

Par exemple, le quatrième nombre N4 est compris entre 1 et 20.

Les pointillés entre une sortie S et une entrée E de deux premiers circuits 12 sur la figure 4 indiquent que le dispositif de détection 100 peut comprendre d'autres premiers circuits 12 intercalés entre ces deux premiers circuits 12.

Par exemple, le cinquième nombre N5 est égal à un.

En variante, le cinquième nombre N5 est compris entre 1 et 5.

Par exemple, le sixième nombre N6 est égal à un.

En variante, le sixième nombre N6 est compris entre 1 et 5.

Chaque premier circuit 12 de la pluralité de premiers circuits est analogue à un circuit 12 d'un dispositif de détection 10 décrit en référence à la figure 1.

Chaque premier circuit 12 s'étend dans un premier plan P1.

Chaque premier plan P1 est normal à la troisième direction Z.

Les premiers circuits 12 sont superposés les uns par rapport aux autres selon la troisième direction Z.

Les premiers plans P1 sont parallèles les uns aux autres.

Ainsi, les segments 18, 20, 22 d'un premier circuit 12 sont superposés selon la troisième direction Z avec chaque autre segment 18, 20, 22 respectif des autres premiers circuits 10.

Chaque deuxième circuit 102 comprend une piste conductrice 104 propre à être parcourue par le courant de polarisation $I_p$. Chaque deuxième circuit 102 comprend aussi une entrée E et une sortie S.

Chaque deuxième circuit 102 s'étend dans un deuxième plan P2 respectif. Chaque deuxième plan P2 est normal à la troisième direction Z. Chaque deuxième plan P2 est donc parallèle à chaque premier plan P1.

La piste conductrice 104 de chaque deuxième circuit présente la forme d'un serpentin.

La piste conductrice 104 s'étend dans le deuxième plan P2.

La piste conductrice 104 comporte une pluralité de segments 106 et des parties de raccordement 108 raccordant les segments 106 entre eux.

Chaque segment 106 s'étend le long de la deuxième direction Y.

Les segments 106 sont superposés les uns aux autres selon la première direction X.

Les segments 106 sont ordonnés selon la première direction X de sorte qu'il est possible de définir un ordre des segments 106 dans le sens allant de l'entrée E vers la sortie S du deuxième circuit 102.

Par exemple, chaque deuxième circuit 102 comprend un septième nombre de segments 106, noté N7. Le septième nombre N7 est égal au nombre total de segments 18, 20, 22 de chaque premier circuit 12, c'est-à-dire à la somme du premier nombre N1, du deuxième nombre N2 et du troisième nombre N3.

Chaque deuxième circuit 102 est dépourvu d'élément détecteur 40 de champ magnétique. Par exemple, dans une technologie de circuits supraconducteurs, chaque deuxième circuit 102 est dépourvu de jonction Josephson.

La pluralité de premiers circuits 12 est intercalée entre au moins deux deuxièmes circuits 102 consécutifs selon la troisième direction Z.

Chaque segment 106 d'un deuxième circuit 102 est superposé avec un segment respectif 18, 20, 22 de chaque premier circuit 12 selon la troisième direction Z. Autrement dit, chaque deuxième circuit 102 présente des espacements correspondants aux espacements E1, E2 et E3 de chaque premier circuit 12 projetés orthogonalement dans chaque plan P2.

Un ordre des circuits d'extrémité 102 est défini par rapport à la direction du courant de polarisation $I_p$ dans la troisième direction Z. La direction du courant de polarisation $I_p$ est également représentée par la flèche F2, parallèle à la troisième direction Z. Il est alors défini au moins un circuit d'entrée noté 102E et au moins un circuit de sortie $102_S$ définis par rapport à la direction du courant de polarisation $I_p$ représentée par la flèche F2.

Ainsi, chaque circuit d'entrée 102E est identifié par un indice j et noté respectivement $102E_j$. L'indice j est un nombre entier et, dans l'exemple illustré, l'indice j variant de 1 au cinquième nombre N5. L'indice j est omis lorsqu'un circuit d'entrée 102E quelconque est désigné.

De la même manière, chaque circuit de sortie 102S est identifié par un indice q et noté respectivement $102S_q$. L'indice q est un nombre entier et, dans l'exemple illustré, l'indice q varie de 1 au sixième nombre N6. L'indice q est omis lorsqu'un circuit de sortie 102S quelconque est désigné.

Dans l'exemple illustré sur la figure 4, le cinquième nombre N5 est égal à un et le sixième nombre N6 est également égal à 1. Ainsi, le dispositif de détection 100 comprend un unique circuit d'entrée notée $102E_1$ et un unique circuit de sortie, noté $102S_1$.

Un premier circuit 12 est dénommé dans la suite de la description « circuit intermédiaire 12 ».

Un ordre des circuits intermédiaires 12 est également défini par rapport à la direction du courant de po-larisation $I_p$ représenté par la flèche F2 de sorte que chaque circuit intermédiaire 12 est identifié par un indice m et noté $12_m$. L'indice m est un nombre entier et, dans l'exemple illustré, l'indice m variant de 1 à N4. L'indice m est omis lorsqu'un circuit intermédiaire 12 quelconque est désigné.

Il est alors défini un premier circuit intermédiaire 12, et il est défini un dernier circuit intermédiaire $12_{N4}$ selon la direction de circulation du courant de polarisation $I_p$ représentée par la flèche F2.

Le générateur 14 de courant de polarisation $I_p$ est relié à l'entrée E de l'unique circuit d'entrée $102E_1$.

La sortie S de l'unique circuit d'entrée $102E_1$ est connectée à l'entrée E du premier circuit intermédiaire $12_1$.

En particulier, la sortie S de l'unique circuit d'entrée $102E_1$ et l'entrée E du premier circuit intermédiaire $12_1$ sont connectées ensemble par un fil de connexion qui s'étend dans le plan XZ et qui forme un angle non nul avec la troisième direction Z.

La sortie S et l'entrée E de deux circuits intermédiaires 12 consécutifs sont connectées entre elles.

En particulier, la sortie S et l'entrée E de deux circuits intermédiaires 12 consécutifs sont connectées ensemble par un fil de connexion qui s'étend dans le plan XZ et qui forme un angle non nul avec la troisième direction Z.

La sortie S du dernier circuit intermédiaire $12_{N4}$ est connectée à l'entrée E de l'unique circuit de sortie $102S_1$.

En particulier, la sortie S du dernier circuit intermédiaire $12_{N4}$ est connectée à l'entrée E de l'unique circuit de sortie 102S, par un fil de connexion qui s'étend dans le plan XZ et qui forme un angle non nul avec la troisième direction Z.

En fonctionnement du dispositif de détection 100, le courant de polarisation $I_p$ entre par l'entrée E du circuit d'entrée $102E_1$, parcourt le circuit d'entrée $102E_1$ et arrive à la sortie S du circuit d'entrée $102E_1$, puis le courant de polarisation $I_p$ entre par l'entrée E du premier circuit intermédiaire $12_1$, parcourt les circuits intermédiaires 12 et sort à la sortie S du dernier circuit intermédiaire $12_{N4}$.

Le courant de polarisation $I_p$ sortant du dernier circuit intermédiaire $12_{N4}$ entre par l'entrée E du circuit de sortie 102S, et parcourt le circuit de sortie 102S, jusqu'à la sortie S du circuit de sortie $102S_1$.

Les portions d'entrée 34, les portions de sortie 36 de chaque circuit intermédiaire 12 ainsi que les circuits d'extrémité 102 parcourus par le courant de polarisation $I_p$ sont propres à générer le champ magnétique correctif.

Ainsi, un dispositif de détection 100 compact est obtenu. En outre, le dispositif de détection obtenu permet de réduire le champ auto-induit induit par le courant de polarisation $I_p$ dans les portions intermédiaires 38 des circuits intermédiaires 12.

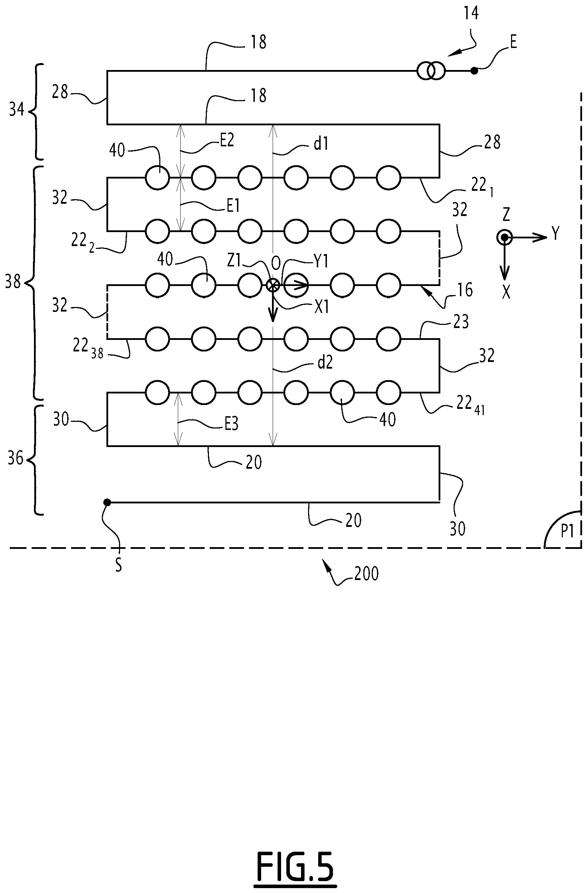

Un troisième mode de réalisation du dispositif de détection est décrit en référence à la figure 5. Le dispositif de détection dans ce troisième mode de réalisation est identifié par la référence numérique 200.

Ce mode de réalisation est décrit par différence au premier mode de réalisation défini en référence à la figure 1.

Dans ce mode de réalisation, le premier nombre N1 est supérieur ou égal à deux. En particulier, le premier nombre N1 est égal à deux.

En variante, le premier nombre N1 est compris entre 2 et 5.

Dans ce mode de réalisation, le deuxième nombre N2 est supérieur ou égal à deux. En particulier, le deuxième nombre N2 est égal à deux.

En variante, le deuxième nombre N2 est compris entre 2 et 5.

Dans ce mode de réalisation, la coordonnée xE de la portion d'entrée 34 correspond à la position sur le premier axe X1 du segment d'entrée 18 directement relié au premier segment intermédiaire $22_1$.

En outre, dans ce mode de réalisation, la coordonnée xS de la portion de sortie 36 correspond à la position sur le premier axe X1 du segment de sortie 20 directement relié au dernier segment intermédiaire $22_{N3}$.

Dans ce mode de réalisation, la longueur $L_E$ de la portion d'entrée 34 et la longueur $L_S$ de la portion de sortie 36 sont augmentées. En effet, le premier nombre N1 est égal à deux fois le premier nombre N1 du premier mode de réalisation et le deuxième nombre N2 est égal à deux fois le deuxième nombre N2 du premier mode de réalisation.

Du fait que le nombre N1 et le nombre N2 sont chacun plus importants que le premier nombre N1 et le deuxième nombre N2 du premier mode de réalisation, le champ auto-induit est encore mieux compensé.

En outre, du fait de l'agencement en méandre de la portion d'entrée 34 et de la portion de sortie 36, un dispositif de détection 200 compact est obtenu.

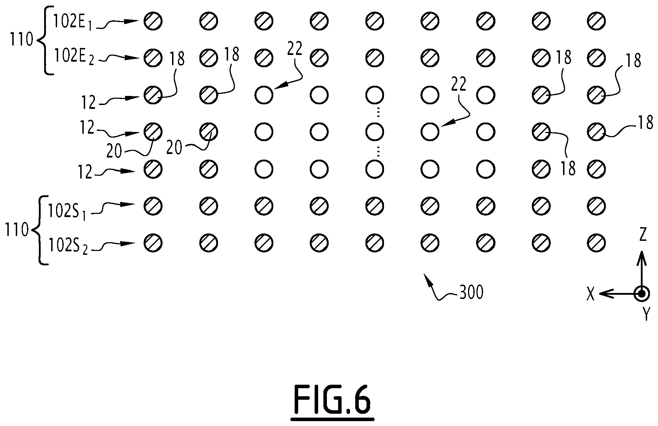

Un quatrième mode de réalisation du dispositif de détection est représenté en référence à la figure 6. Ce mode de réalisation est décrit uniquement par différence au deuxième mode de réalisation décrit en référence à la figure 4.

Dans ce mode de réalisation, le dispositif de détection est identifié par la référence numérique 300.

La figure 6 représente une vue en coupe du dispositif de détection 300 dans le plan de coupe normal à la deuxième direction Y.

Par exemple, le cinquième nombre N5 est égal à deux et le sixième nombre N6 est également égal à 2. Ainsi, le dispositif de détection 300 comprend deux circuits d'entrée 102E et deux circuits de sortie 102S.

Dans ce mode de réalisation, chaque premier circuit 12 est analogue au premier circuit 12 du troisième mode de réalisation décrit en référence à la figure 5.

En outre, chaque circuit d'entrée 102E et chaque circuit de sortie est analogue respectivement à un circuit d'entrée 102E et à un circuit de sortie 102S du troisième mode de réalisation décrit en référence à la figure 4.

Sur la figure 6, pour chaque premier circuit 12, les segments intermédiaires 22 vus en coupe sont représentés par des ronds vides et les segments d'entrée 18 et les segments de sortie 20 sont représentés par des ronds hachurés.

Les segments 106 des deuxièmes circuits 102 vus en coupe sont également représentés schématiquement par des ronds hachurés.

Les deuxièmes circuits 102 sont agencés en paires 110 de circuits d'entrée $102E_1$, $102E_2$ et en paire de circuits de sortie $102S_1$ et $102S_2$. Chaque paire 110 de deuxièmes circuits 102 est superposée l'une par rapport à l'autre selon la troisième direction Z.

Dans le cas illustré sur la figure 6, les premiers circuits 12 sont intercalés entre les deux paires 110 de deuxièmes circuits 102.

En fonctionnement du dispositif de détection 300, le courant de polarisation $I_p$ entre par l'entrée E du premier circuit d'entrée $102E_1$, parcourt le premier circuit d'entrée $102E_1$ et sort par la sortie S du premier circuit d'entrée $102E_1$. Puis le courant $I_p$ entre par l'entrée E du deuxième circuit d'entrée $102E_2$, parcourt le deuxième circuit d'entrée $102E_2$ et sort par la sortie S du deuxième circuit d'entrée $102E_2$. Ensuite, le courant de polarisation $I_p$ entre par l'entrée E du premier circuit intermédiaire $12_1$, parcourt les circuits intermédiaires 12 et sort à la sortie S du dernier circuit intermédiaire $12_{N4}$. Le courant de polarisation $I_p$ sortant du dernier circuit intermédiaire $12_{N4}$ entre par l'entrée E du premier circuit de sortie $102S_1$, parcourt le premier circuit de sortie 102S, jusqu'à la sortie S du premier circuit de sortie 102S, et enfin entre par l'entrée E du deuxième circuit de sortie, parcourt le deuxième circuit de sortie $102S_2$ et sort par la sortie S du deuxième circuit de sortie $102S_2$.

En variante, le cinquième nombre N5 est strictement supérieur à 2 et le sixième nombre N6 est strictement supérieur à 2.

Dans un tel cas, en fonctionnement, le courant $I_p$ parcourt d'abord tous les circuits d'entrée 102E puis les circuits intermédiaires 12 et enfin tous les circuits de sortie 102S.

Par exemple, le cinquième nombre N5 est égal au sixième nombre N6.

En variante, le cinquième nombre N5 et le sixième nombre N6 sont différents.

Dans ce mode de réalisation, le cinquième nombre N5 de circuits d'entrée 102E est augmenté et le sixième nombre N6 de circuits de sortie 102S est également augmenté. Ainsi, le champ auto-induit est encore mieux compensé par rapport à un dispositif de détection ayant un cinquième nombre N5 et un sixième nombre N6 de deuxièmes circuits 102 plus faibles.

En outre, les circuits intermédiaires 12 et les paires 110 de circuits d'entrée 102E et de circuits de sortie 102S étant empilés les uns sur les autres selon la troisième direction Z, un dispositif de détection 300 particulièrement compact est obtenu.

Un cinquième mode de réalisation (non représenté sur les figures) est à présent décrit.

Ce mode de réalisation est uniquement décrit par différence au premier mode de réalisation des figures 1 à 3.

Dans le cinquième mode de réalisation, le troisième nombre N3 de segments intermédiaires 22 est un nombre pair. A titre d'illustration, le troisième nombre N3 est égal à 40.

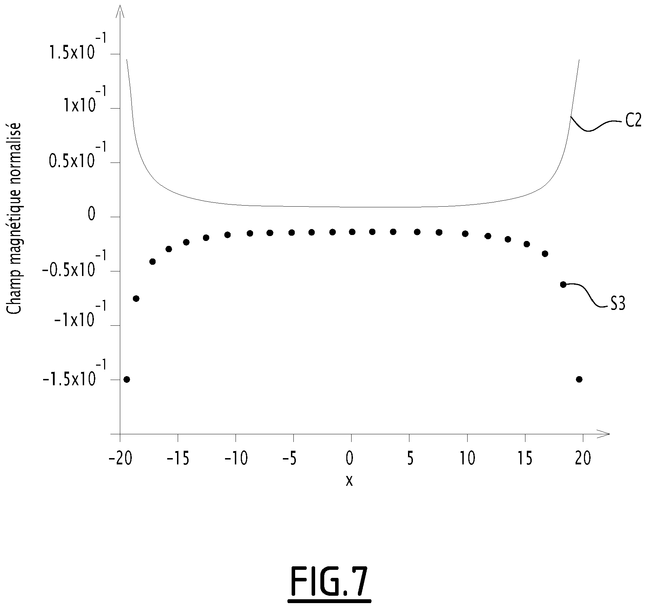

La figure 7 est un graphique comportant une série de données S3 et une courbe C2. La série de données S3 correspond à la valeur du champ parasite auto-induit aux points où sont positionnés les segments $22_k$ repérés par la première coordonnée spatiale x dans le cas où la piste conductrice 16 est dépourvue de portion d'entrée 34 et de portion de sortie 36. Cette série de données peut être approximée par une troisième fonction, notée $g_N$ :

$$g_{N(x)} = \sum_{i=1}^{N} \frac{J_p}{x - \xi_p}$$

où

- N est choisi en fonction de la précision de compensation du champ auto-induit parasite souhaitée
- $\xi_p$ et $J_p$ sont des paramètres d'ajustement, les coefficients $J_p$ sont proportionnels au courant $I_p$ circulant dans la partie centrale 38.

L'expression de la fonction $g_N$ peut aussi être vue comme le champ magnétique généré par un système de N segments conducteurs placés aux points $\xi_p$, p étant un nombre entier variant de 1 à N.

De préférence, N est égal à la somme du premier nombre N1 et du deuxième nombre N2 et le premier nombre N1 est égal au deuxième nombre N2.

A titre d'illustration, on choisit N=2. Ainsi, le premier nombre N1 est égal à un et le deuxième nombre N2 est également égal à un.

Dans le cas où le troisième nombre N3 nombre de segments intermédiaires 22 est pair, par symétrie, $J_1 = -J_2$, et $\xi_2 = -\xi_1$.

Alors, le champ parasite peut être évalué aux points d'abscisses $x_k$ des segments 22k par une quatrième fonction notée $g_2$.

Où:

$$x_k = E1.\left(k - \frac{N3+1}{2}\right), k = 1 \ldots N3$$

et

$$g_2(x_k) = J_1.\left(\frac{1}{x_k - \xi_1} - \frac{1}{x_k + \xi_1}\right).$$

L'expression de la fonction $g_2$ peut être vue comme le champ magnétique généré par deux segments conducteurs placés en $\xi_1$ et $\xi_2 = -\xi_1$. Avec la disposition en méandre espacés régulièrement, $\xi_1$ est strictement inférieur à $x_1$ et $\xi_2$ est strictement supérieur à $x_{N3}$. Ces deux segments conducteurs forment le segment d'entrée 18 et le segment de sortie 20 des portions d'entrée 34 et de sortie 36, propres à générer un champ auto-induit correctif.

La courbe C2 représente la variation de la quatrième fonction $g_2$ en fonction de la coordonnée spatiale x de telle sorte que le champ magnétique résultant soit compensé.

En particulier, la courbe C2 représente la formule analytique définissant le paramètre d'ajustement $\xi_1$ par ajustement numérique.

Le paramètre $\xi_1$ est choisi pour que pour chacune des valeurs de coordonnée spatiale $x_k$ des segments intermédiaires $22_k$, la valeur de champ magnétique normalisé correctif représentée par la courbe C2 est opposée à la valeur correspondante de champ magnétique auto-induit normalisée de la série S4.

La valeur du paramètre d'ajustement $\xi_1$ donne les coordonnées xE, xS du segment d'entrée 18 et du segment de sortie 20, respectivement.

Ainsi, la coordonnée xE du segment d'entrée 18 est égal à $-\xi_1$ et la coordonnée du segment de sortie 20 est égale à $+\xi_1$.

Dans le présent exemple, xE est égal à -20,2 multiplié par le premier espacement E1 et xS égal à 20,2 multiplié par le premier espacement E1.

En outre, la coordonnée $x_1$ étant par exemple égale à -19,5*E1, le deuxième espacement E2 est égal à la valeur absolue de la différence entre xE et $x_1$. Ainsi, le deuxième espacement E2 est égal à 0,7 multiplié par le premier espacement E1. De même, le troisième espacement E3 est égal à la valeur absolue de la différence entre xS et $x_{N3}$. Ainsi, le troisième espacement E3 est égal à 0,7 multiplié par le premier espacement E1.

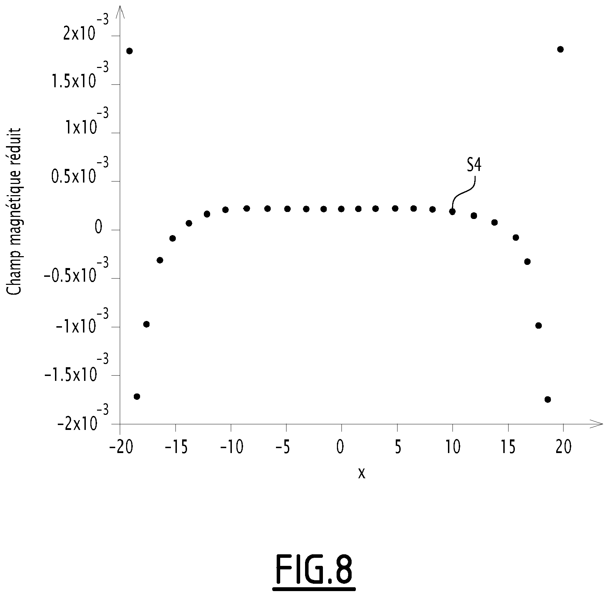

La figure 8 est un graphique comportant une série de points S4.

La série S4 est le champ parasite résiduel au niveau des segments lorsque le circuit comprend une portion d'entrée 34 et une portion de sortie 36, autrement dit lorsque le champ auto-induit a été compensé.

Lorsque le troisième nombre N3 de segments intermédiaires 22 est pair, grâce à la portion d'entrée 34 et à la portion de sortie 38, le champ magnétique auto-induit par les éléments détecteurs 40 de champ magnétique est réduit en 1/N3.

Ainsi, grâce à la portion d'entrée 34 et la portion de sortie 36, le champ auto-induit est fortement diminué.

**Revendications**

1. Dispositif (10 ; 100 ; 200 ; 300) de détection de champ magnétique comportant un circuit (12) propre à être parcouru par un courant de polarisation ($I_p$),

le circuit (12) comprenant au moins une piste conductrice (16) propre à être parcourue par le courant de polarisation ($I_p$), la piste conductrice (16) ayant la forme d'un serpentin,
la piste conductrice (16) comprenant :

- une portion d'entrée (34), la portion d'entrée (34) présentant une longueur ($L_E$),
- une portion de sortie (36), la portion de sortie (36) présentant une longueur ($L_S$), et
- une portion intermédiaire (38) pour laquelle il est défini un centre O, la portion intermédiaire (38) étant intercalée entre la portion d'entrée (34) et la portion de sortie (36), la portion intermédiaire (38) comprenant une pluralité d'éléments détecteurs (40) de champ magnétique, la portion d'entrée (34) et la portion de sortie (36) étant dépourvues d'élément détecteur (40) de champ magnétique,

**caractérisé en ce que** la longueur ($L_E$) de la portion d'entrée (34), la longueur ($L_S$) de la portion de sortie (36), la distance ($d_1$) entre la portion d'entrée (34) et le centre (O) et la distance ($d_2$) entre la portion de sortie (36) et le centre (O) sont telles que le champ auto-induit par les éléments détecteurs (40) de champ magnétique est diminué d'au moins 99% par rapport au champ auto-induit par un élément détecteur d'une piste conductrice dépourvue de portion d'entrée et de portion de sortie.

2. Dispositif de détection selon la revendication 1, dans lequel la portion d'entrée (34) comprend un premier nombre (N1) de segments d'entrée (18) et dans lequel la portion de sortie (36) comprend un deuxième nombre (N2) de segments de sortie (20), le premier nombre (N1) étant égal au deuxième nombre (N2).

3. Dispositif de détection selon la revendication 1 ou 2, dans lequel le premier nombre (N1) est supérieur ou égal à deux et le deuxième nombre (N2) est supérieur ou égal à deux.

4. Dispositif de détection selon l'une quelconque des revendications 1 à 3, dans lequel la portion intermédiaire (38) comprend une pluralité de segments (22), dits segments intermédiaires, le nombre (N3) de segments intermédiaires (22) étant de préférence supérieur ou égal à trois, le nombre de segments intermédiaires (22) étant de préférence impair.

5. Dispositif de détection selon la revendication 4, dans lequel chaque segment intermédiaire (22) comprend deux portions d'extrémité (22A, 22B) et une portion médiane (22C) présentant chacun une longueur ($L_A$,

$L_B$, $L_C$), les éléments détecteurs (40) de champ magnétique étant répartis sur la portion médiane (22C) du segment intermédiaire (22), la longueur ($L_C$) de la portion médiane (22C) étant, de préférence, inférieure à 80% de la longueur (L) du segment intermédiaire (22).

6. Dispositif de détection selon l'une quelconque des revendications 1 à 5, dans lequel au moins l'un des éléments détecteurs (40) de champ magnétique est un dispositif de détection à interférence quantique, le dispositif de détection à interférence quantique comprenant au moins une jonction Josephson.

7. Dispositif de détection de champ magnétique, comprenant:

- une pluralité de premiers circuits (12), chaque premier circuit étant un circuit (12) d'un dispositif de détection (10) selon l'une quelconque des revendications 1 à 6, chaque premier circuit (12) s'étendant dans un premier plan (P1) respectif, et
- au moins deux deuxièmes circuits (102), chaque deuxième circuit (102) comprenant une piste conductrice (104) propre à être parcourue par le courant de polarisation ($I_p$), chaque deuxième circuit (102) s'étendant dans un deuxième plan (P2) respectif, chaque deuxième circuit (102) étant dépourvu d'élément détecteur (40) de champ magnétique,
la pluralité de premiers circuits (12) étant intercalée entre l'un des deuxièmes circuits (102) parmi les au moins deux deuxièmes circuits et un autre deuxième circuit (102) parmi les au moins deux deuxièmes circuits, et la pluralité de premiers circuits (12) étant connectée électriquement aux au moins deux deuxièmes circuits (102).

8. Dispositif de détection de champ magnétique selon la revendication 7, dans lequel les premiers plans (P1) sont parallèles entre eux et chaque deuxième plan (P2) est également parallèle à chaque premier plan (P1),
les premiers circuits (12) de la pluralité de premiers circuits étant empilés selon une direction normale (Z) à chaque premier plan (P1).

9. Dispositif de détection selon la revendication 8, dans lequel la portion d'entrée (34) de chaque premier circuit (12) comprend un premier nombre (N1) de segments d'entrée (18), la portion de sortie (36) de chaque premier circuit (12) comprend un deuxième nombre (N2) de segments de sortie (20) et la portion intermédiaire (38) de chaque premier circuit (12) comprend un troisième nombre (N3) de segments intermédiaires (22), et la piste conductrice (104) de chaque deuxième circuit (102) comprend un nombre (N7) de segments (106), le nombre (N7) de segments (106) de chaque deuxième circuit (102) étant égal à la somme des premier, deuxième et troisième nombres (N1, N2, N3), et le premier nombre (N1) étant, de préférence, égal au deuxième nombre (N2).

**Patentansprüche**

1. Vorrichtung (10; 100; 200; 300) zur Erfassung eines Magnetfelds mit einem Schaltkreis (12), der von einem Vorspannungsstrom ($I_p$) durchflossen werden kann,

   wobei der Schaltkreis (12) mindestens eine Leiterbahn (16) umfasst, die geeignet ist, von dem Vorspannungsstrom ($I_p$) durchflossen zu werden, wobei die Leiterbahn (16) serpentinenförmig ist,
   die Leiterbahn (16) umfasst:

   - einen Eingangsabschnitt (34), wobei der Eingangsabschnitt (34) eine Länge ($L_E$) aufweist,
   - einen Ausgangsabschnitt (36), wobei der Ausgangsabschnitt (36) eine Länge ($L_S$) aufweist, und
   - einen Zwischenabschnitt (38), für den ein Zentrum O definiert ist, wobei der Zwischenabschnitt (38) zwischen dem Eingangsabschnitt (34) und dem Ausgangsabschnitt (36) angeordnet ist, wobei der Zwischenabschnitt (38) eine Vielzahl von Magnetfeldsensorelementen (40) umfasst, wobei der Eingangsabschnitt (34) und der Ausgangsabschnitt (36) frei von Magnetfeldsensorelementen (40) sind,

   **dadurch gekennzeichnet, dass** die Länge ($L_E$) des Eingangsabschnitts (34), die Länge ($L_S$) des Ausgangsabschnitts (36), der Abstand ($d_1$) zwischen dem Eingangsabschnitt (34) und dem Zentrum (O) und der Abstand ($d_2$) zwischen dem Ausgangsabschnitt (36) und dem Zentrum (O) derart sind, dass das von den Sensorelementen (40) selbst induzierte Feld um mindestens 99% im Vergleich zu dem Feld, das von einem Sensorelement einer Leiterbahn ohne Eingangs- und Ausgangsabschnitt selbst induziert wird, verringert wird.

2. Erfassungsvorrichtung nach Anspruch 1, wobei der Eingangsabschnitt (34) eine erste Anzahl (N1) von Eingangssegmenten (18) umfasst und wobei der Ausgangsabschnitt (36) eine zweite Anzahl (N2) von Ausgangssegmenten (20) umfasst, wobei die erste Anzahl (N1) gleich der zweiten Anzahl (N2) ist.

3. Erfassungsvorrichtung nach Anspruch 1 oder 2, wobei die erste Anzahl (N1) größer oder gleich zwei ist und die zweite Anzahl (N2) größer oder gleich zwei ist.

4. Erfassungsvorrichtung nach einem der Ansprüche 1 bis 3, wobei der Zwischenabschnitt (38) eine Vielzahl von Segmenten (22) umfasst, die als Zwischensegmente bezeichnet werden, wobei die Anzahl (N3) der Zwischensegmente (22) vorzugsweise größer oder gleich drei ist, wobei die Anzahl der Zwischensegmente (22) vorzugsweise ungerade ist.

5. Erfassungsvorrichtung nach Anspruch 4, bei der jedes Zwischensegment (22) zwei Endabschnitte (22A, 22B) und einen Mittelabschnitt (22C) mit jeweils einer Länge ($L_A$, $L_B$, $L_C$) umfasst, wobei die Magnetfeldsensoren (40) über den Mittelabschnitt (22C) des Zwischensegments (22) verteilt sind, wobei die Länge ($L_C$) des Zwischenabschnitts (22C) vorzugsweise weniger als 80% der Länge (L) des Zwischensegments (22) beträgt.

6. Erfassungsvorrichtung nach einem der Ansprüche 1 bis 5, wobei mindestens eines der Magnetfeldsensorelemente (40) eine Quanteninterferenz-Erfassungsvorrichtung ist, wobei die Quanteninterferenz-Erfassungsvorrichtung mindestens einen Josephson-Übergang umfasst.

7. Erfassungsvorrichtung von Magnetfeldern, umfassend:

   - eine Vielzahl von ersten Schaltkreisen (12), wobei jeder erste Schaltkreis ein Schaltkreis (12) einer Erfassungsvorrichtung (10) nach einem der Ansprüche 1 bis 6 ist, wobei sich jeder erste Schaltkreis (12) in einer jeweiligen ersten Ebene (P1) erstreckt, und
   - mindestens zwei zweite Schaltkreise (102), wobei jeder zweite Schaltkreis (102) eine Leiterbahn (104) umfasst, die von dem Vorspannungsstrom ($I_p$) durchflossen werden kann, wobei jeder zweite Schaltkreis (102) sich in einer jeweiligen zweiten Ebene (P2) erstreckt, wobei jeder zweite Schaltkreis (102) kein Magnetfelddetektorelement (40) aufweist,
   die Vielzahl erster Schaltkreise (12) zwischen einem der zweiten Schaltkreise (102) der mindestens zwei zweiten Schaltkreise und einem weiteren zweiten Schaltkreis (102) der mindestens zwei zweiten Schaltkreise, wobei die Vielzahl von ersten Schaltkreisen (12) elektrisch mit den mindestens zwei zweiten Schaltkreisen (102) verbunden ist.

8. Magnetfelderfassungsvorrichtung nach Anspruch 7, bei der die ersten Ebenen (P1) parallel zueinander sind und jede zweite Ebene (P2) ebenfalls parallel zu jeder ersten Ebene (P1) ist,

wobei die ersten Schaltkreise (12) der Vielzahl von ersten Schaltkreisen in einer Richtung senkrecht (Z) zu jeder ersten Ebene (P1) gestapelt sind.

9. Erfassungsvorrichtung nach Anspruch 8, wobei der Eingangsabschnitt (34) jedes ersten Schaltkreises (12) eine erste Anzahl (N1) von Eingangssegmenten (18) umfasst, der Ausgangsabschnitt (36) jedes ersten Schaltkreises (12) eine zweite Anzahl (N2) von Ausgangssegmenten (20) umfasst und der Zwischenabschnitt (38) jedes ersten Schaltkreises (12) eine dritte Anzahl (N3) von Zwischensegmenten (22) aufweist, und die Leiterbahn (104) jedes zweiten Schaltkreises (102) eine Anzahl (N7) von Segmenten (106) aufweist, wobei die Anzahl (N7) von Segmenten (106) jedes zweiten Schaltkreises (102) gleich der Summe der ersten, zweiten und dritten Anzahl (N1, N2, N3) ist, und die erste Anzahl (N1) vorzugsweise gleich der zweiten Anzahl (N2) ist.

**Claims**

1. Magnetic field detection device (10; 100; 200; 300) comprising a circuit (12) through which a bias current ($I_p$) can flow,

   the circuit (12) comprising at least one conductive track (16) through which the bias current ($I_p$) can flow, the conductive track (16) being in the form of a coil,
   the conductor track (16) comprising:

   - an inlet portion (34), the inlet portion (34) having a length ($L_E$),
   - an outlet portion (36), the outlet portion (36) having a length ($L_S$), and
   - an intermediate portion (38) for which a centre O is defined, the intermediate portion (38) being interposed between the input portion (34) and the output portion (36), the intermediate portion (38) comprising a plurality of magnetic field detector elements (40), the input portion (34) and the output portion (36) being devoid of magnetic field detector elements (40),

   **characterised in that** the length ($L_E$) of the input portion (34), the length ($L_S$) of the output portion (36), the distance ($d_1$) between the input portion (34) and the centre (O) and the distance ($d_2$) between the output portion (36) and the centre (O) are such that the field self-induced by the magnetic field detector elements (40) is reduced by at least 99% compared with the field self-induced by a detector element of a conductive track without an input portion and without an output portion.

2. A detection device as claimed in claim 1, wherein the input portion (34) comprises a first number (N1) of input segments (18) and wherein the output portion (36) comprises a second number (N2) of output segments (20), the first number (N1) being equal to the second number (N2).

3. A detection device according to claim 1 or 2, in which the first number (N1) is greater than or equal to two and the second number (N2) is greater than or equal to two.

4. A detection device according to any one of claims 1 to 3, in which the intermediate portion (38) comprises a plurality of segments (22), referred to as intermediate segments, the number (N3) of intermediate segments (22) preferably being greater than or equal to three, the number of intermediate segments (22) preferably being odd.

5. A detection device according to claim 4, in which each intermediate segment (22) comprises two end portions (22A, 22B) and a median portion (22C) each having a length ($L_A$, $L_B$, $L_C$), the magnetic field detector elements (40) being distributed over the median portion (22C) of the intermediate segment (22), the length ($L_C$) of the median portion (22C) preferably being less than 80% of the length (L) of the intermediate segment (22).

6. A detection device according to any one of claims 1 to 5, wherein at least one of the magnetic field sensing elements (40) is a quantum interference sensing device, the quantum interference sensing device comprising at least one Josephson junction.

7. A magnetic field detection device comprising:

   - a plurality of first circuits (12), each first circuit being a circuit (12) of a detection device (10) according to any one of claims 1 to 6, each first circuit (12) extending in a respective first plane (P1), and
   - at least two second circuits (102), each second circuit (102) comprising a conductive track (104) through which the bias current ($I_p$) can flow, each second circuit (102) extending in a respective second plane (P2), each second circuit (102) having no magnetic field detector element (40), the plurality of first circuits (12) being interposed between one of the second circuits (102) of the at least two second circuits and another of the second circuits (102) of the at least two second circuits, and the plurality of first circuits (12) being electrically connected to the at least two second circuits (102).

8. A magnetic field detection device as claimed in claim 7, wherein the first planes (P1) are parallel to each other and each second plane (P2) is also parallel to each first plane (P1),
the first circuits (12) of the plurality of first circuits being stacked in a direction (Z) normal to each first plane (P1).

9. A detection device according to claim 8, wherein the input portion (34) of each first circuit (12) comprises a first number (N1) of input segments (18), the output portion (36) of each first circuit (12) comprises a second number (N2) of output segments (20) and the intermediate portion (38) of each first circuit (12) comprises a third number (N3) of intermediate segments (22), and the conductor track (104) of each second circuit (102) comprises a number (N7) of segments (106), the number (N7) of segments (106) of each second circuit (102) being equal to the sum of the first, second and third numbers (N1, N2, N3), and the first number (N1) preferably being equal to the second number (N2).

## FIG.1

# FIG.2

**FIG.3**

## FIG.4

## FIG.5

FIG.6

## FIG.7

**FIG.8**

## RÉFÉRENCES CITÉES DANS LA DESCRIPTION

**Littérature non-brevet citée dans la description**

- **LABBÉ et al.** *Effects of flux pinning on the DC characteristics of meander-shaped superconducting quantum interférence filters with flux concentrator*

- **CYBART et al.** *Comparison of measurements and simulations of series-parallel incommensurate area superconductivity quantum interférence device arrays fabricated from YBa2Cu7O7-$\delta$ ion damage Josephson junctions*
- **KORNEV et al.** *Broadband active electrically small superconductor antennas*